Europäisches Patentamt

European Patent Office

Office européen des brevets

(19)

(11) Numéro de publication : **0 120 744**
**B1**

(12)

# FASCICULE DE BREVET EUROPÉEN

(45) Date de publication du fascicule du brevet :
**22.10.86**

(21) Numéro de dépôt : **84400379.8**

(22) Date de dépôt : **24.02.84**

(51) Int. Cl.⁴ : **H 03 B 19/14**

(54) Diviseur de fréquence par deux, analogique et apériodique.

(30) Priorité : **02.03.83 FR 8303413**

(43) Date de publication de la demande :
**03.10.84 Bulletin 84/40**

(45) Mention de la délivrance du brevet :
**22.10.86 Bulletin 86/43**

(84) Etats contractants désignés :
**DE GB IT NL SE**

(56) Documents cités :
**EP-A- 0 060 153**
**US-A- 3 938 061**
**INTERNATIONAL JOURNAL OF ELECTRONICS, vol.
43, no. 2, août 1977, pages 185-191, Londres, GB A.
AMMAR et al.: "A sinusoidal frequency divider using
field-effect transistor"**

(73) Titulaire : **THOMSON-CSF**
**173, Boulevard Haussmann**
**F-75379 Paris Cedex 08 (FR)**

(72) Inventeur : **Kantorowicz, Gérard**
**THOMSON-CSF SCPI 173, bld Haussmann**
**F-75379 Paris Cedex 08 (FR)**
Inventeur : **Kaminsky, Didier**
**THOMSON-CSF SCPI 173, bld Haussmann**
**F-75379 Paris Cedex 08 (FR)**

(74) Mandataire : **Taboureau, James et al**
**THOMSON-CSF SCPI 19, avenue de Messine**
**F-75008 Paris (FR)**

EP 0 120 744 B1

## Description

La présente invention concerne un diviseur de fréquence à très grande rapidité, fonctionnant dans le domaine des hyperfréquences, et utilisant essentiellement deux transistors à effet de champ à double grille. Le montage utilisé pour les deux transistors à effet de champ, qui travaillent en parallèle en tant que fonction produit et sommation, permet de supprimer le filtre qui est généralement incorporé dans les diviseurs analogiques par 2 : ainsi le diviseur selon l'invention, n'étant plus limité par la bande passante d'un filtre, fonctionne dans une gamme de fréquence comprise entre le continu et la fréquence maximale des transistors. -

La fréquence maximale d'utilisation du diviseur selon l'invention est améliorée par le fait que les deux transistors à effet de champ travaillant en parallèle, le diviseur ne présente qu'un seul étage, ce qui est un avantage par rapport aux diviseurs connus du type à deux états commutés dans lesquels les temps de propagation des différents étages s'additionnent.

Enfin, puisque le filtre est supprimé, et que le diviseur comporte essentiellement deux transistors, il devient plus aisé de l'intégrer sur une pastille semiconductrice, selon la technologie des circuits intégrés. Cette intégration n'est pas possible avec les diviseurs comportant un filtre qui, en hyperfréquence, est réalisé sous forme de lignes microbandes dont les dimensions sont telles qu'elles nécessitent un substrat du genre circuit hybride, sur lequel sont fixés le transistor et les inductances et capacités. La réalisation d'un tel circuit hybride sur une pastille de silicium ou d'arséniure de gallium est envisageable mais elle est d'un prix prohibitif. Par contre, la réalisation du diviseur selon l'invention en circuits intégrés est tout à fait industrielle.

Le diviseur selon l'invention traite deux signaux d'entrée à la fréquence F, complémentaires, c'est-à-dire en opposition de phase, sur ses deux entrées en parallèle. Chacun de ces signaux est appliqué à la deuxième grille d'un transistor à effet de champ, dont la première grille reçoit une partie du signal de sortie du diviseur, par une boule de réaction. Par convention, la grille voisine de la source est dite première grille, et la grille voisine du drain est dite seconde grille. Les signaux de sortie des deux transistors à effet de champ réalisant le produit des fonctions appliquées à leurs deux grilles sont sommés, et, comme les signaux d'entrée sont complémentaires, la sommation annule certaines fréquences non désirables produites par les mélanges. Le signal de sortie est donc à la fréquence F/2.

De façon plus précise l'invention concerne un diviseur de fréquence par 2, analogique et apériodique, d'un signal périodique à fréquence F, fonctionnant dans une très large gamme de fréquences, comme connu par la demande de brevet français FR-A-2 500 694, le diviseur de l'invention étant caractérisé en ce qu'il comporte :

— un premier dispositif semiconducteur réalisant le produit de deux fonctions, qui reçoit sur une première borne d'entrée un premier signal, à fréquence F,

— un second dispositif semiconducteur réalisant le produit de deux fonctions, qui reçoit sur une première borne d'entrée un second signal, à fréquence F, en opposition de phase avec le premier signal, les deux dispositifs réalisant le produit de deux fonctions étant montés en parallèle,

— un amplificateur-sommateur qui reçoit sur ses deux entrées les signaux issus des deux dispositifs et fournit sur sa borne de sortie un signal, de forme périodique, à fréquence F/2, dont une partie est retournée, à travers une double boucle de réaction, vers les dispositifs et appliquée aux secondes bornes d'entrées desdits dispositifs,

— chacun des deux dispositifs réalisant le produit de deux fonctions étant constitué par un transistor à effet de champ, à deux grilles qui en constituent les deux entrées, chaque transistor assurant également, par son gain, l'étage d'amplification du diviseur de fréquence dont la sortie est prise sur les drains, réunis, des deux transistors.

L'invention sera mieux comprise par la description qui suit de deux exemples de réalisation, laquelle s'appuie sur les figures jointes en annexe et qui représentent :

figure 1   schéma fonctionnel d'un diviseur de fréquence selon l'art connu,

figure 2   schéma fonctionnel d'un diviseur de fréquence selon l'invention,

figure 3   forme des signaux aux entrées et sortie du diviseur selon l'invention,

figure 4   premier exemple de réalisation d'un diviseur par 2 selon l'invention,

figure 5   second exemple de réalisation d'un diviseur par 2 selon l'invention.

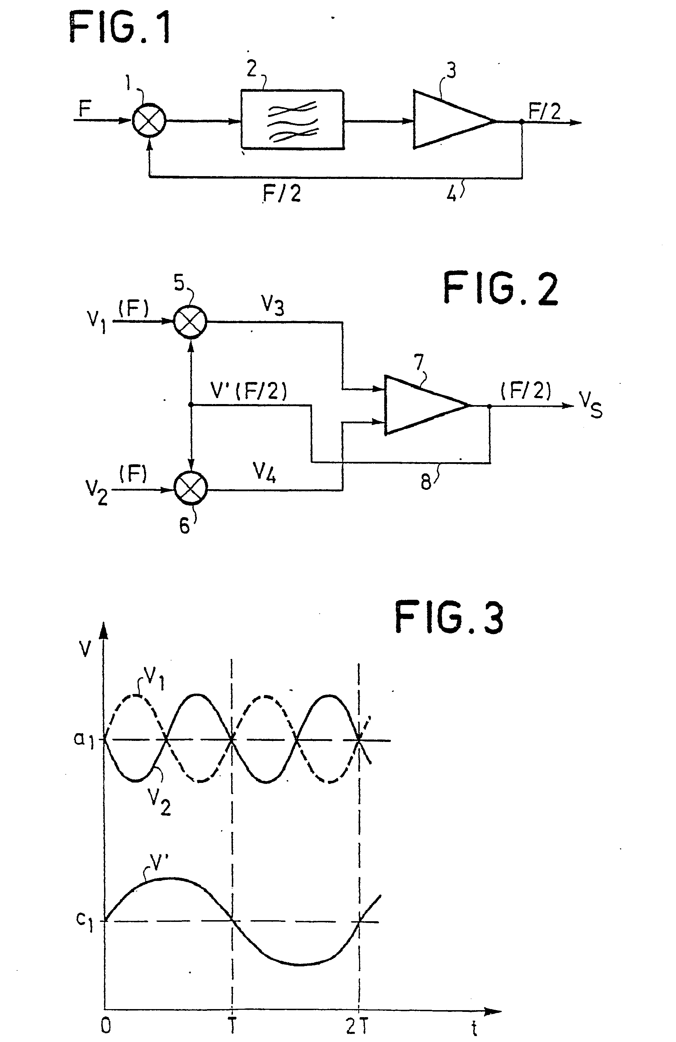

Le diviseur par 2 selon l'invention peut être qualifié d'analogique, par opposition aux diviseurs de fréquence numériques à deux états commutés. En effet, les diviseurs numériques connus emploient des circuits de type bascule bistable comportant plusieurs composants en cascade, et présentant des temps de propagation et des éléments parasites non négligeables en très haute fréquence, ce qui en limite la fréquence maximale d'utilisation. Les diviseurs analogiques connus comportent un mélangeur, un amplificateur, un filtre et une boucle de réaction. Dans le brevet français N° 81 03621, publié sous le N° FR-A-2 500 694 et déposé par la Demanderesse, suivant le schéma fonctionnel représenté en figure 1, les fonctions mélange, amplification et boucle de réaction sont assurées par un seul composant, qui est un transistor à effet de champ à deux grilles, d'où une réduction des temps de transit et des connexions parasites. Mais ce circuit comporte encore un filtre passe-bande.

Le schéma fonctionnel d'un tel diviseur par 2 est en soi connu depuis longtemps, et c'est la structure d'application qui fait l'objet du brevet cité ci-dessus. Un signal d'entrée à une fréquence F est appliqué sur une première entrée d'un mélangeur 1, dont le signal de sortie est filtré par un filtre passe-bande 2 puis amplifié par un amplificateur 3 qui fournit sur sa sortie un signal à la fréquence F/2. Une partie du signal de sortie à la fréquence F/2 est prélevé par une boucle de contre-réaction et appliquée sur une seconde entrée du mélangeur 1. Dans ce schéma, les positions de l'amplificateur 3 et du filtre passe-bande 2 peuvent être inversées. Il est connu que ce type de diviseur par 2 fonctionne parce qu'une oscillation apparaît à une fréquence sous-harmonique du signal d'entrée, et démarre soit sur une transitoire soit sur un bruit, cette oscillation étant filtrée, amplifiée et régénérée par le mélangeur qui favorise ainsi la fréquence F/2 à l'exclusion de toute autre, uniquement lorsque la fréquence F est appliquée sur la première entrée du mélangeur.

La réalisation du diviseur par 2 décrite dans le brevet ci-dessus fait appel pour le mélangeur et pour l'amplificateur à un unique transistor à effet de champ à deux grilles. Cependant, étant donné que ce type de mélangeur est destiné à fonctionner dans de très hautes fréquences, telles que 20 GHz par exemple, le filtre passe-bande 2 est réalisé selon la technologie des microbandes, connue sous le nom anglais de micro-strip, lesquelles consistent en des métallisations déposées sur un substrat isolant. Les dimensions de ces bandes métalliques font qu'il n'est pas question, d'un point de vue industriel, de les déposer sur la pastille semiconductrice dans laquelle est fabriqué le transistor à effet de champ. On aboutit donc à une sorte de circuit hybride, dont le substrat supporte d'une part la pastille semiconductrice du transistor à effet de champ, et d'autre part, les microbandes qui constituent le filtre, ainsi d'ailleurs que les transformateurs de couplage d'entrée ou de sortie.

Le diviseur par 2 selon l'invention constitue un progrès par rapport aux diviseurs de la figure 1 en ce sens qu'il supprime le filtre passe-bande 2 et que dès lors il est possible de réaliser l'ensemble du diviseur selon la technologie de circuit intégré, sur une même pastille semiconductrice.

La figure 2 représente le schéma fonctionnel d'un diviseur de fréquence par 2 selon l'invention. Celui-ci comporte deux mélangeurs réalisant un produit de fonctions 5 et 6 et un amplificateur sommateur 7. Une boucle de réaction 8 prélève le signal à la sortie du sommateur, et la retourne sur l'une des entrées de chacun des deux mélangeurs 5 et 6.

Le fonctionnement du diviseur par deux apériodiques selon l'invention, nécessite que les deux signaux $V_1$ et $V_2$ à la fréquence F appliqués aux deux mélangeurs 5 et 6, soient des signaux complémentaires, c'est-à-dire en opposition de phase, tels que représentés sur la figure 3. Ces signaux ont la forme, pour la simplicité de l'exposé, des signaux sinusoïdaux :

$$V_1 = a_1 + b_1 \sin \omega t$$
$$V_2 = a_1 - b_1 \sin \omega t$$

dans laquelle $a_1$ et $b_1$ sont des constantes et $\omega$ la pulsation.

Le signal V' à la fréquence F/2, qui est prélevé à la sortie du diviseur de fréquence est appliqué sur la deuxième entrée des mélangeurs 5 et 6. Etant donné la forme des signaux d'entrée $V_1$ et $V_2$, le signal V' a la forme :

$$V' = c_1 + d_1 \sin \frac{\omega t}{2}.$$

On sait que le produit p de deux fonctions f et g, effectué par le dispositif mélangeur comporte des termes de premier, second, troisième ordre et ainsi de suite, et les mélangeurs 5 et 6 fournissent chacun un produit de la forme :

$$p = fg + f^2 g + fg^2 + f^2 g^2 + \cdots$$

Si l'on néglige les termes du produit autres que ceux du premier ordre, en particulier parce que les transistors n'ont plus suffisamment de gain à de telles fréquences, que leurs caractéristiques sont suffisamment linéaires et que leurs signaux correspondants sont négligeables, et compte tenu du fait que les mélangeurs 5 et 6 conservent la composante continue, les signaux de sortie des deux mélangeurs ont pour expression :

$$V_3 = k(a_1 + b_1 \sin \omega t)\left(c_1 + d_1 \sin \frac{\omega t}{2}\right)$$

$$V_4 = k(a_1 - b_1 \sin \omega t)\left(c_1 + d_1 \sin \frac{\omega t}{2}\right)$$

k étant un facteur de proportionnalité, lié aux transistors mélangeurs.

Le signal de sortie de l'amplificateur est donc de la forme :

$$V_s = k_s(V_3 + V_4)$$

$$= 2 kk_s a_1\left(c_1 + d_1 \sin \frac{\omega t}{2}\right)$$

**0 120 744**

$k_s$ étant un facteur de proportionnalité lié au circuit sommateur.

Le signal de sortie $V_s$ est bien proportionnel au signal $V'$ et le retour d'une fraction du signal de sortie de l'amplificateur vers le point commun aux deux mélangeurs constitue une double boucle cohérente, ce qui permet à cette double boucle d'osciller à la fréquence F/2 lorsque et seulement lorsque les deux signaux complémentaires $V_1$ et $V_2$ à la fréquence F sont appliqués aux mélangeurs 5 et 6.

Le diviseur par 2 selon l'invention démarre sur une transitoire ou sur un bruit, qui développe une fréquence F/2, à la sortie de l'amplificateur 7, ce qui permet d'accrocher le fonctionnement du diviseur.

L'un des avantages de l'invention est que les fonctions amplification, sommation et produit conservant la composante continue du signal d'entrée peuvent être réalisées au moyen d'un seul transistor à effet de champ à double grille, c'est-à-dire en tout deux transistors à effet de champ puisque le diviseur selon l'invention comporte deux branches.

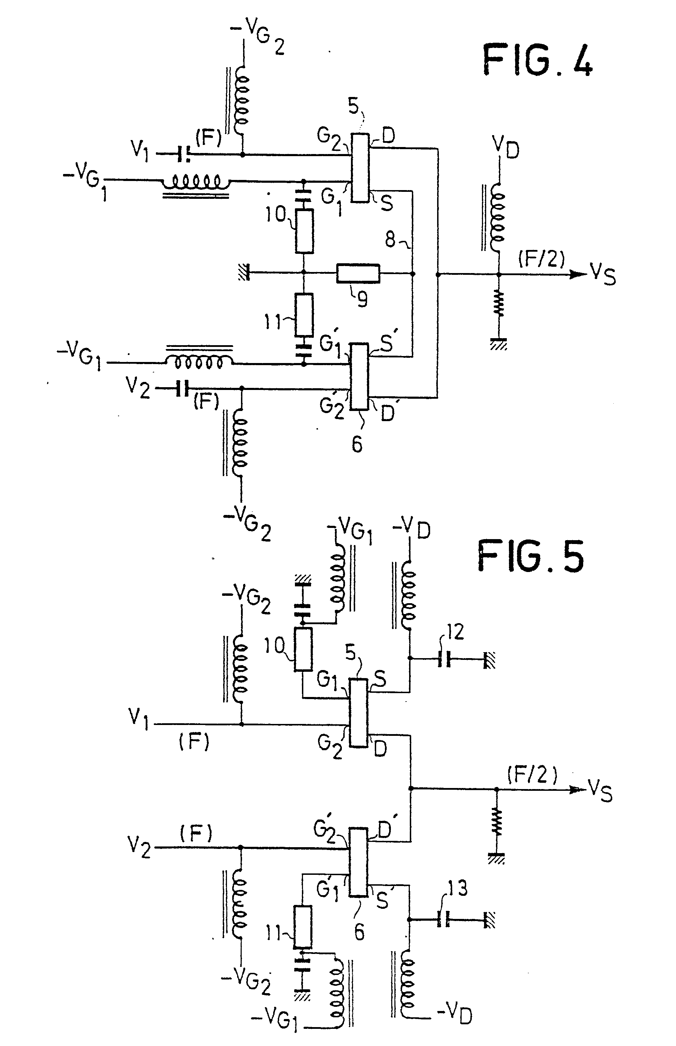

La figure 4 représente un premier exemple de schéma de réalisation d'un diviseur par 2 avec deux transistors à effet de champ 5 et 6. Les deux transistors sont montés avec leurs drains D et D' en parallèle, et les grilles $G_2$ pour le transistor 5 et $G'_2$ pour le transistor 6, voisines des drains, sont attaquées respectivement par le signal à diviser présent sous la forme d'un signal en phase $V_1$ et du même signal mais en opposition de phase $V_2$. La double boucle de réaction est constituée par une boucle entre la source et l'autre grille de chacun des deux transistors 5 et 6, cette autre grille constituant la seconde entrée des mélangeurs.

Dans ce type de schéma, la réaction, ou la boucle de réaction 8, est donc réalisée, pour le premier transistor 5, par une impédance 9 branchée sur la source S et une impédance 10 branchée sur la première grille $G_1$, ces deux impédances étant mises à la masse pour les hyperfréquences ; pour le transistor 6 par la même impédance 9 branchée sur la source S' et une impédance 11 branchée sur la première grille $G'_1$, ces deux impédances étant également mises à la masse.

Des tensions de polarisation — $V_{G2}$ et $V_D$ alimentent les grilles $G_2$ et $G'_2$ des deux transistors et leurs drains D et D' montés en parallèle, de façon à assurer une polarisation continue des deux transistors.

Chacun des deux transistors 5 et 6 constitue donc un mélangeur entre les signaux à fréquence F et le signal à fréquence F/2 ; il constitue également l'amplificateur de sortie du dispositif. Le fait que les sorties prélevées sur les deux drains soient réunies en un point commun assure la fonction de sommation, et comme chacun des deux mélangeurs fournit à sa sortie des signaux comportant des harmoniques, telles que F,F + F/2, etc... ces harmoniques s'annulent réciproquement par la fonction de sommation, parce qu'ils sont en opposition de phase. Par contre, la fréquence F/2 qui est adressée par la double boucle de réaction sur les premières grilles $G_1$ et $G'_1$ des deux transistors à effet de champ 5 et 6 ne s'annule pas puisqu'il n'y a pas de tension à la fréquence F/2 en opposition de phase.

La figure 5 représente un second exemple de diviseur par 2, dans lequel les deux transistors 5 et 6 sont alimentés en drains communs pour créer une réaction intrerne. Comme dans l'exemple de la figure 4, les signaux à diviser sont appliqués en opposition de phase sur les grilles $G_2$ et $G'_2$ voisines des drains D et D' des transistors. Dans ce schéma, ces grilles $G_2$ et $G'_2$ sont également polarisées par une tension de polarisation —$V_{G2}$ destinée à assurer une composante continue du signal sur les transistors. Les grilles $G_1$ et $G'_1$ sont contre-réactionnées par des impédances 10 et 11 connectées à la masse. Les sorties des deux transistors prélevées sur les drains D et D' son connectées en un point commun qui fournit une tension de sortie $V_s$ à la fréquence F/2. Mais les sources S et S' sont alimentées par deux tensions continues de polarisation — VD, découplées par rapport à la masse par des capacités 12 pour le transistor 5 et 13 pour le transistor 6.

Dans les deux exemples donnés en figure 4 et 5, il est remarquable que le diviseur de fréquence selon l'invention ne comporte qu'un seul étage entre ses entrées sur les grilles $G_2$ et $G'_2$ et sa sortie sur les drains D et D', cet unique étage étant composé de deux transistors à effet de champ qui travaillent en parallèle. Ainsi, par rapport à des diviseurs par 2 selon l'art connu qui comportent un étage de mélange, un étage d'amplification, lesquels peuvent être confondus, mais également un étage de filtre, le diviseur selon l'invention, qui ne comporte plus de filtre, a donc un temps de transfert ou de propagation qui est beaucoup plus court, ce qui permet de travailler à de plus hautes fréquences que les diviseurs connus. En fait, la gamme de fréquence du diviseur selon l'invention qui n'est plus limitée par un filtre, s'étend depuis les très basses fréquences voisines du courant continu jusqu'aux fréquences maximales d'utilisation des transistors 5 et 6. Si les deux transistors ont une fréquence de fonctionnement jusqu'à 25 GHz par exemple, la fréquence de fonctionnement du diviseur est comprise entre environ 0 et 25 GHz.

La réalisation du diviseur selon l'invention fait appel à des transistors à effet de champ de préférence à grilles Schottky. Les impédances 9, 10 et 11, ne comportent en général qu'une partie réactive. Ces réactances, inductances ou capacités peuvent être réalisées pour les secondes selon la technique d'une couche de diélectrique, par exemple nitrure de silicium, comprise entre deux couches de matériaux conducteurs, ou sous forme interdigitée. Les premières sont réalisées sous la forme de rubans conducteurs. La réalisation des impédances est facile puisque le circuit ne comportant que deux transistors à effet de champ et trois impédances, il peut être facilement intégré sur une pastille de matériaux semiconducteurs, dans laquelle les impédances sont réalisées simultanément avec certaines opérations de réalisation des transistors à effet de champ.

Le diviseur selon l'invention fonctionne depuis les très basses fréquences, et il est possible de le réaliser dans des matériaux tels que le silicium. Mais il est surtout intéressant aux très hautes fréquences, et dans ce cas sa réalisation sur des matériaux rapides tels que GaAs par exemple est préférable. Le diviseur par 2 selon l'invention qui présente donc sur les diviseurs connus l'avantage de pouvoir être réalisé sous forme de circuit intégré est utilisé dans tous les domaines de la microélectronique, et particulièrement pour la division de fréquence en hyperfréquence, dans le domaine des GHz, pour les boucles d'asservissement en fréquence des émetteurs-récepteurs de télécommunications.

**Revendications**

1. Diviseur de fréquence par 2, analogique et apériodique, d'un signal de forme périodique à fréquence F, fonctionnant dans une très large gamme de fréquences, caractérisé en ce qu'il comporte :
— un premier dispositif semiconducteur (5) réalisant le produit de deux fonctions, qui reçoit sur une première borne d'entrée un premier signal ($V_1$), à fréquence F,
— un second dispositif semiconducteur (6) réalisant le produit de deux fonctions, qui reçoit sur une première borne d'entrée un second signal ($V_2$), à fréquence F, en opposition de phase avec le premier signal ($V_1$), les deux dispositifs (5, 6) réalisant le produit de deux fonctions étant montés en parallèle,
— un amplificateur-sommateur (7) qui reçoit sur ses deux entrées les signaux ($V_3$, $V_4$) issus des deux dispositifs (5, 6) et fournit sur sa borne de sortie un signal (V'), de forme périodique, à fréquence F/2, dont une partie est retournée, à travers une double boucle de réaction, vers les dispositifs (5, 6) et appliquée aux secondes bornes d'entrées desdits dispositifs,
— chacun des deux dispositifs (5, 6) réalisant le produit de deux fonctions étant constitué par un transistor à effet de champ, à deux grilles ($G_1$, $G_2$) qui en constituent les deux entrées, chaque transistor assurant également, par son gain, l'étage d'amplification (7) du diviseur de fréquence dont la sortie est prise sur les drains (D, D'), réunis, des deux transistors.
2. Diviseur de fréquence selon la revendication 1, caractérisé en ce qu'il comporte :
— un premier transistor à effet de champ (5), à double grille, dont la deuxième grille ($G_2$), polarisée par une tension continue ($-V_{G2}$), reçoit un signal périodique ($V_1$) de fréquence F, la boucle de réaction de ce premier transistor étant constituée par une première impédance (9) connectée entre la masse et la source (S) du transistor, et par une deuxième impédance (10) connectée entre la masse et la première grille ($G_1$) du transistor,
— un second transistor à effet de champ (6), à double grille, dont la deuxième grille ($G'_2$,) polarisée par une tension continue ($-V_{G2}$), reçoit un signal périodique ($V_2$), de fréquence F, en opposition de phase avec le signal ($V_1$) appliqué au premier transistor (5), la boucle de réaction de ce second transistor étant constituée par une première impédance (9) connectée entre la masse et la source (S') du transistor, et par une troisième impédance (11) connectée entre la masse et la première grille ($G'_1$) du transistor,
— les drains (D, D') des deux transistors (5, 6), polarisés par une tension continue ($V_D$) étant réunis en un point qui constitue la sortie du diviseur de fréquence, qui fournit une tension ($V_s$) à fréquence F/2.
3. Diviseur de fréquence selon la revendication 1, caractérisé en ce qu'il comporte :
— un premier transistor à effet de champ (5), à double grille, dont la deuxième grille ($G_2$), polarisée par une tension continue ($-V_{G2}$), reçoit un signal périodique ($V_1$) de fréquence F, et dont la première grille ($G_1$) est connectée à la masse à travers une première impédance (10), la source (S) de ce transistor, couplée à la masse par une capacité (12) étant polarisée par une tension continue ($-V_D$), la boucle de réaction de ce premier transistor étant constituée par une réaction interne entre les grilles ($G_1$, $G_2$) et le drain (D) du transistor,
— un second transistor à effet de champ (6), à double grille, dont la deuxième grille ($G'_2$), polarisée par une tension continue ($-V_{G2}$), reçoit un signal périodique ($V_2$), de fréquence F, en opposition de phase avec le signal ($V_1$) appliqué au premier transistor, et dont la première grille ($G'_1$) est connectée à la masse à travers une seconde impédance (11), la source (S') de ce transistor, couplée à la masse par une capacité (13) étant polarisée par une tension continue ($-V_D$), la boucle de réaction de ce second transistor étant constituée par une réaction interne entre les grilles ($G'_1$, $G'_2$) et le drain (D') du transistor,
— les drains (D, D') des deux transistors (5, 6) étant réunis en un point qui constitue la sortie du diviseur de fréquence, qui fournit une tension ($V_s$) à fréquence F/2.
4. Diviseur de fréquence selon la revendication 1, caractérisé en ce qu'il présente un seul étage entre ses bornes d'entrées et de sortie, cet unique étage étant constitué par deux transistors à effet de champ (5, 6) en parallèle, la fréquence maximale d'utilisation du diviseur étant égale à la fréquence maximale de fonctionnement des transistors (5, 6).
5. Diviseur de fréquence selon la revendication 1, caractérisé en ce que les transistors (5, 6) sont des transistors à grilles de type Schottky, et en ce que les impédances de contre-réaction (9, 10, 11) sont réalisées par dépôts de couches diélectriques entre des couches conductrices, sur le substrat des transistors (5, 6), et par dépôts de couches conductrices sur le substrat des transistors (5, 6).
6. Diviseur de fréquence selon la revendication 5, caractérisé en ce qu'il est réalisé selon la technologie des circuits intégrés, sur une pastille de matériau semiconducteur.

**Claims**

1. Analog and aperiodic frequency divider by 2 for dividing a periodic signal of frequency F

5

# 0 120 744

functioning in a very wide frequency band, characterized in that it comprises :

— a first semiconductor device (5) forming the product of two functions which receives at its first input terminal a first signal ($V_1$) of frequency F,

— a second semiconductor device (6) forming the product of two functions which receives at a first input terminal a second signal ($V_2$) of frequency F opposite in phase to the first signal ($V_1$), the two devices (5, 6) forming the product of two functions being connected in parallel,

— an amplifier summator (7) which receives at its two inputs the signals ($V_3$, $V_4$) furnished by the two devices (5, 6) and supplies at its output terminal a signal (V') of periodic form and of frequency F/2, of which a part is returned through a double feedback loop to the devices (5, 6) and applied to the second input terminals of said devices,

— each of the two devices (5, 6) forming the product of two functions being constituted by a field-effect transistor having two gates ($G_1$, $G_2$) forming the two inputs thereof, each transistor also forming by its gain the amplifier stage (7) of the frequency divider whose output is taken from the two interconnected drains (D, D') of the two transistors.

2. Frequency divider according to claim 1, characterized in that it comprises :

— a first double gate field-effect transistor (5) whose second gate ($G_2$), polarized by a dc voltage (— $V_{G2}$), receives a periodic signal ($V_1$) of frequency F, the feedback loop of said first transistor being formed by a first impedance (9) connected between ground and the source (S) of the transistor and by a second impedance (10) connected between ground and the first gate ($G_1$) of the transistor,

— a second double gate field-effect transistor (6), of which the second gate ($G'_2$), polarized by a dc voltage (— $V_{G2}$), receives a periodic signal ($V_2$) of frequency F of opposite phase to the signal ($V_1$) applied to the first transistor (5), the feedback loop of said second transistor being formed by a first impedance (9) connected between ground and the source (S') of the transistor and by a third impedance (11) connected between ground and the first gate ($G'_1$) of the transistor,

— the drains (D, D') of the two transistors (5, 6), polarized by a dc voltage ($V_D$), being connected to a point which forms the output of the frequency divider and furnishes a voltage ($V_s$) of frequency F/2.

3. Frequency divider according to claim 1, characterized in that it comprises :

— a first double gate field-effect transistor (5) of which the second gate ($G_2$), polarized by a dc voltage (— $V_{G2}$), receives a periodic signal ($V_1$) of frequency F and of which the first gate ($G_1$) is connected to ground through a first impedance (10), the source (S) of said transistor being connected to ground through a capacitance (12) and polarized by a dc voltage (— $V_D$), the feedback loop of this first transistor being formed by an internal reaction between the gates ($G_1$, $G_2$) and the drain (D) of the transistor,

— a second double gate field-effect transistor (6), of which the second gate ($G'_2$) is polarized by a dc voltage (— $V_{G2}$), receives a periodic signal ($V_2$) of frequency F of opposite phase to the signal applied to the first transistor, and of which the first gate ($G'_1$) is connected via a second impedance (11) to ground, the source electrode (S') of said transistor, coupled to ground via a capacitance (13), being polarized by a dc voltage (— $V_D$), the feedback loop of said second transistor being formed by an internal reaction between the gates ($G'_1$, $G'_2$) and the drain (D') of the transistor,

— the drains (D, D') of the two transistors (5, 6) are connected together at a point which forms the output of the frequency divider and furnishes a voltage ($V_s$) of frequency F/2.

4. Frequency divider according to claim 1, characterized in that it comprises a single stage between its input terminal and its output terminal, said single stage being formed by two field-effect transistors (5, 6) in parallel, the maximum operating frequency of the divider being equal to the maximum operating frequency of the transistors (5, 6).

5. Frequency divider according to claim 1, characterized in that the transistors (5, 6) are transistors of Schottky type gates and that the negative feedback impedancies (9, 10, 11) are formed by depositions of dielectric layers between conductive layers on the substrate of the transistors (5, 6) and by depositions of conductive layers on the substrate of the transistors (5, 6).

6. Frequency divider according to claim 5, characterized in that it is made in integrated circuit technology on a semiconductor material wafer.

## Patentansprüche

1. Frequenzteiler, welcher durch 2 teilt und analog sowie aperiodisch ausgebildet ist, zum Teilen eines periodischen Signals der Frequenz F, mit einem sehr breiten Arbeitsfrequenzbereich, dadurch gekennzeichnet, daß er umfaßt :

— eine erste Halbleitervorrichtung (5), welche das Produkt von zwei Funktionen bildet und an einem ersten Eingangsanschluß ein erstes Signal ($V_1$) der Frequenz F empfängt,

— eine zweite Halbleitervorrichtung (6), welche das Produkt von zwei Funktionen bildet und an einem ersten Eingangsanschluß ein zweites Signal ($V_2$) der Frequenz F mit entgegengesetzter Phasenlage zu dem ersten Signal ($V_1$) empfängt, wobei die zwei Vorrichtungen (5, 6), welche das Produkt von zwei Funktionen bilden, parallel geschaltet sind,

— einen Verstärker-Summierer (7), welcher an seinen zwei Eingängen die Signale ($V_3$, $V_4$) empfängt,

6

welche von den zwei Vorrichtungen (5, 6) abgegeben werden und an seinem Ausgangsanschluß ein periodisches Signal (V') der Frequenz F/2 liefert, wovon ein Teil über eine doppelte Rückkopplungsschleife zu den Vorrichtungen (5, 6) zurückgeführt und an die zweiten Eingangsanschlüsse dieser Vorrichtungen angelegt wird,

— wobei jede dieser zwei Vorrichtungen (5, 6), die das Produkt von zwei Funktionen bilden, durch einen Feldeffekttransistor mit zwei Gates ($G_1$, $G_2$) gebildet ist, die seine zwei Eingänge bilden, wobei jeder Transistor ferner durch seine Verstärkung die Verstärkerstufe (7) des Frequenzteilers bildet, dessen Ausgang an den beiden miteinander verbundenen Drains (D, D') der zwei Transistoren abgegriffen wird.

2. Frequenzteiler nach Anspruch 1, dadurch gekennzeichnet, daß er umfaßt :

— einen ersten Feldeffekttransistor (5) mit doppeltem Gate, dessen zweites Gate ($G_2$) durch eine Gleichspannung (— $V_{G2}$) vorgespannt ist und ein periodisches Signal ($V_1$) der Frequenz F empfängt, wobei die Rückkopplungsschleife dieses ersten Transistors durch eine erste Impedanz (9) gebildet ist, welche zwischen die Masse und die Source-Elektrode (S) des Transistors geschaltet ist, sowie durch eine zweite Impedanz (10) gebildet ist, die zwischen Masse und das erste Gate ($G_1$) des Transistors geschaltet ist,

— einen zweiten Feldeffekttransistor (6) mit doppeltem Gate, wovon das zweite Gate ($G'_2$) durch eine Gleichspannung (— $V_{G2}$) vorgespannt ist und ein periodisches Signal ($V_2$) der Frequenz F empfängt, welches die entgegengesetzte Phasenlage wie das an den ersten Transistor (5) angelegte Signal ($V_1$) aufweist, wobei die Rückkopplungsschleife dieses zweiten Transistors durch eine erste Impedanz (9), die zwischen Masse und die Source-Elektrode (S') des Transistors geschaltet ist, und durch eine dritte Impedanz (11) gebildet ist, die zwischen Masse und das erste Gate ($G'_1$) des Transistors geschaltet ist,

— wobei die Drains (D, D') der zwei Transistoren (5, 6), die durch eine Gleichspannung ($V_D$) vorgespannt sind, an einem Punkt verbunden sind, welcher den Ausgang des Frequenzteilers bildet und eine Spannung ($V_s$) der Frequenz F/2 liefert.

3. Frequenzteiler nach Anspruch 1, dadurch gekennzeichnet, daß er umfaßt :

— einen ersten Feldeffekttransistor (5) mit doppeltem Gate, wovon das zweite Gate ($G_2$) durch eine Gleichspannung (— $V_{G2}$) vorgespannt ist und ein periodisches Signal ($V_1$) der Frequenz F empfängt, während das erste Gate ($G_1$) mit Masse über eine erste Impedanz (10) verbunden ist, wobei die Source-Elektrode (S) dieses Transistors über eine Kapazität (12) mit Masse verbunden und durch eine Gleichspannung (— $V_D$) vorgespannt ist, wobei die Rückkopplungsschleife dieses ersten Transistors durch eine innere Rückwirkung zwischen den Gates ($G_1$, $G_2$) und dem Drain (D) des Transistors gebildet ist,

— einen zweiten Feldeffekttransistor (6) mit doppeltem Gate, wovon das zweite Gate ($G'_2$) durch eine Gleichspannung (— $V_{G2}$) vorgespannt ist und ein periodisches Signal ($V_2$) der Frequenz F empfängt, das die entgegengesetzte Phasenlage wie das an den ersten Transistor angelegte Signal ($V_1$) aufweist, während das erste Gate ($G'_1$) über eine zweite Impedanz (11) mit Masse verbunden ist, wobei die Source-Elektrode (S') dieses Transistors über eine Kapazität (13) mit Masse verbunden und durch eine Gleichspannung (— $V_D$) vorgespannt ist, und wobei die Rückkopplungsschleife dieses zweiten Transistors durch eine innere Rückwirkung zwischen den Gates ($G'_1$, $G'_2$) und dem Drain (D') des Transistors gebildet ist,

— wobei die Drains (D, D') dieser zwei Transistoren (5, 6) an einem Punkte miteinander verbunden sind, welcher den Ausgang des Frequentzteilers bildet und eine Spannung ($V_s$) der Frequenz F/2 liefert.

4. Frequenzteiler nach Anspruch 1, dadurch gekennzeichnet, daß er eine einzige Stufe zwischen seinem Eingangsanschluß und seinem Ausgangsanschluß aufweist, wobei diese einzige Stufe durch zwei Feldeffekttransistoren (5, 6) gebildet ist, die parallel geschaltet sind, wobei die maximale Betriebsfrequenz des Teilers gleich der maximalen Betriebsfrequenz der Transistoren (5, 6) ist.

5. Frequenzteiler nach Anspruch 1, dadurch gekennzeichnet, daß die Transistoren (5, 6) Transistoren mit Gates von Schottky-Typ sind, und daß die Gegenkopplungsimpedanzen (9, 10, 11) durch Ablagerungen von dielektrischen Schichten zwischen leitenden Schichten auf dem Substrat der Transistoren (5, 6) und durch Ablagerungen von leitenden Schichten auf dem Substrat der Transistoren (5, 6) gebildet sind.

6. Frequenzteiler nach Anspruch 5, dadurch gekennzeichnet, daß er in der Technik der integrierten Schaltungen auf einem Halbleitermaterialplättchen ausgebildet ist.

# FIG.1

# FIG.2

# FIG.3

# FIG. 4

# FIG. 5

2